# EUROPEAN PATENT SPECIFICATION

(11) **EP 1 118 158 B1**
(45) Date of publication and mention of the grant of the patent: **28.07.2010**
(21) Application number: 99942209.0
(22) Date of filing: 13.08.1999
(51) Int. Cl.: H03M 13/39

(54) **MEMORY ARCHITECTURE FOR MAP DECODER**
SPEICHERARCHITEKTUR FÜR MAP DEKODER
ARCHITECTURE DE MEMOIRE POUR DECODEUR A PROBABILITE MAXIMALE A POSTERIORI

(30) Priority: 14.08.1998 US 96489 P; 26.02.1999 US 259665; 31.03.1999 US 283013
(43) Date of publication of application: 25.07.2001
(73) Proprietor: QUALCOMM INCORPORATED, San Diego, CA 92121-1714 (US)
(72) Inventor: HALTER, Steven, J., San Diego, CA 92129 (US)
(74) Representative: Geyer, Ulrich F.
(86) International application number: PCT/US1999/018550
(87) International publication number: WO 2000/010254

(56) References cited:
- WO-A-97/24850
- VITERBI A J: "AN INTUITIVE JUSTIFICATION AND A SIMPLIFIED IMPLEMENTATION OF THE MAP DECODER FOR CONVOLUTIONAL CODES" IEEE JOURNAL ON SELECTED AREAS IN COMMUNICATIONS,US,IEEE INC. NEW YORK, vol. 16, no. 2, page 260-264 XP000741780 ISSN: 0733-8716
- HALTER S ET AL: "Reconfigurable signal processor for channel coding & decoding in low snr wireless communications" IEEE WORKSHOP ON SIGNAL PROCESSING SYSTEMS 1998, 8 - 10 October 1998, pages 260-274, XP002124485 Cambridge, MA, USA
- HSU J-M ET AL: "A parallel decoding scheme for turbo codes" INTERNATIONAL SYMPOSIUM ON SYSTEMS AND CIRCUITS ISCAS'98 , 31 May 1998 (1998-05-31) - 3 June 1998 (1998-06-03), pages 445-448, XP002124484 Monterey
- FETTWEISS G.; MEYR H.: "Feedforward Architectures for Parallel Viterbi Decoding" JOURNAL ON VLSI SIGNAL PROCESSING, vol. 3, no. 1/2, June 1991 (1991-06), pages 105-119, XP000228897
- DAWID H.; MEYR H.: "Real-Time.Algorithms and VLSI Architectures for Soft Output MAP Convolutional Decoding" PROC. OF PERSONAL, INDOOR AND MOBILE RADIO CONFERENCE (PIMRC) 1995, vol. 1, 27 September 1995 (1995-09-27), pages 193-197, XP002176458 ONTARIO, CANADA

## Description

### I. Field of the Invention

The present invention relates to coding. More particularly, the present invention relates to a novel and improved technique for performing maximum a posteriori probability (MAP) decoding.

### II. Description of the Related Art

"Turbo coding" represents an important advancement in the area of forward error correction (FEC). There are many variants of turbo coding, but most use multiple encoding steps separated by interleaving steps combined with iterative decoding. This combination provides previously unavailable performance with respect to noise tolerance in a communications system. That is, turbo coding allows communications at E_{b}/N₀ levels that were previously unacceptable using the existing forward error correction techniques.

Many systems use forward error correction techniques, and therefore would benefit from the use of turbo coding. For example, turbo codes could improve the performance of wireless satellite links, where the limited downlink transmit power of the satellite necessitates receiver systems that can operate at low E_{b}/N₀ levels. Using turbo codes in a wireless satellite link could reduce the dish size for a digital video broadcast (DVB) system, or alternatively, allow more data to be transmitted within a given frequency bandwidth.

Digital wireless telecommunication systems, such as digital cellular and PCS telephone systems, also use forward error correction. For example, the IS-95 over-the-air interface standard, and its derivatives, such as IS-95B, define a digital wireless communications system that uses convolutional encoding to provide coding gain to increase the capacity of the system. A system and method for processing RF signals substantially in accordance with the use of the IS-95 standard is described in U.S. Patent No. 5,103,459 entitled "System and Method for Generating Signal Waveforms in a CDMA Cellular Telephone System" assigned to the assignee of the present invention ('459 patent).

Because digital wireless communication system like IS-95 are primarily for mobile communications, it is important to have devices that minimize power usage and which are small and light. Typically, this require development of a semiconductor integrated circuit ("chip") for performing most or all of the necessary processing. While convolutional encoring is relatively complex, the circuits necessary to perform convolutional encoding and decoding can be formed on a single chip along with any other necessary circuitry.

Turbo coding (in particular the decoding operation) is significantly more complex than convolutional encoding (and decoding). Nonetheless, it would be highly desirable to include turbo coding in digital wireless telecommunication systems, including mobile digital communication systems and satellite communication system. Thus, the present invention is directed to increasing the rate at which certain decoding operations can be performed, to facilitate the use of turbo coding in a variety of systems.

Further attention is drawn to the document entitled "An intuitive justification and a simplified implementation of the MAP decoder for convolutional codes" by Viterbi A J, IEEE Journal on selected areas in communications, US, IEEE INC New York, vol. 16, no. 2, page 260-264, XP000741780. The document discusses the use of MAP decoders for convolutional codes and also applies memory management techniques similar to those used for ordinary convolutional codes.

Attention is also drawn to the document by G. Fettweiss and H. Meyr, entitled "Feedforward Architectures for Parallel Viterbi Decoding", Journal on VLSI signal processing, vol. 3, no. 2, June 1991, pages 105-119, XP000228897. The document discusses in the context of Viterbi decoding that by no longer processing the ACS-feedback recursively, purely feedforward architectures for Viterbi decoding can be designed.

Finally, attention is drawn to the publication by DAWID H; MEYR H.: 'Real-Time Algorithms and VLSI Architectures for Soft Output MAP Convolutional Decoding' PROC. OF PERSONAL, INDOOR AND MOBILE RADIO CONFERENCE (PIMRC) 1995 vol. 1, 27 September 1995, ONTARIO, CANADA, pages 193 - 197, XP002176458.

### SUMMARY OF THE INVENTION

In the context of the present invention, a system and a method for performing sliding window maximum a posteriori probability decoding, as set forth in claims 1 and 9, are provided. Embodiments of the present invention are described in the dependent claims.

The present invention is a novel and improved technique for decoding technique with particular application to turbo, or iterative, coding techniques. In accordance with one embodiment of the invention, a system for decoding includes a channel deinterleaver RAM for storing a block of symbol estimates, a set, of S state metric calculators. Each state metric calculator is for generating a set of state metric calculations and a set of S+1 window RAMs, wherein, S of said S+1 window RAMs provide symbol estimates to said S state metric calculators. A remaining window RAM receives symbol estimates from said channel deinterleaver RAM.

### BRIEF DESCRIPTION OF THE DRAWINGS

The features, objects, and advantages of the present invention will become more apparent from the detailed description set forth below when taken in conjunction with the drawings in which like reference characters identify correspondingly throughout and wherein:
**FIGS. 1A** and **1B** are block diagrams of wireless communication systems.
**FIG. 2** is a block diagram of an transmit system;
**FIGS. 3A** and **3B** are diagrams of turbo coders;
**FIG. 4** is a block diagram a receive processing system;
**FIG. 5** is a block diagram of decoder and a portion of a channel deinterleaver;
**FIG. 6** is a flow chart illustrating an exemplary set of decoding steps.

### DETAILED DESCRIPTION OF THE PREFERRED EMBODIMENTS

The present invention is a novel and improved technique for performing turbo coding. The exemplary embodiment is described in the context of the digital cellular telephone system. While use within this context is advantageous, different embodiments of the invention may be incorporated in different environments, configurations or digital data transmission systems, including satellite communication systems and wire line communication system such as digital cable and telephone systems.

In general, the various systems described herein may be formed using software controlled processors, integrated circuits, or discrete logic, however, implementation in an integrated circuit is preferred. The data, instructions, commands, information, signals, symbols and chips that may be referenced throughout the application are advantageously represented by voltages, currents, electromagnetic waves, magnetic fields or particles, optical fields or particles, or a combination thereof. In addition, the blocks shown in each block diagram may represent either hardware or method steps.

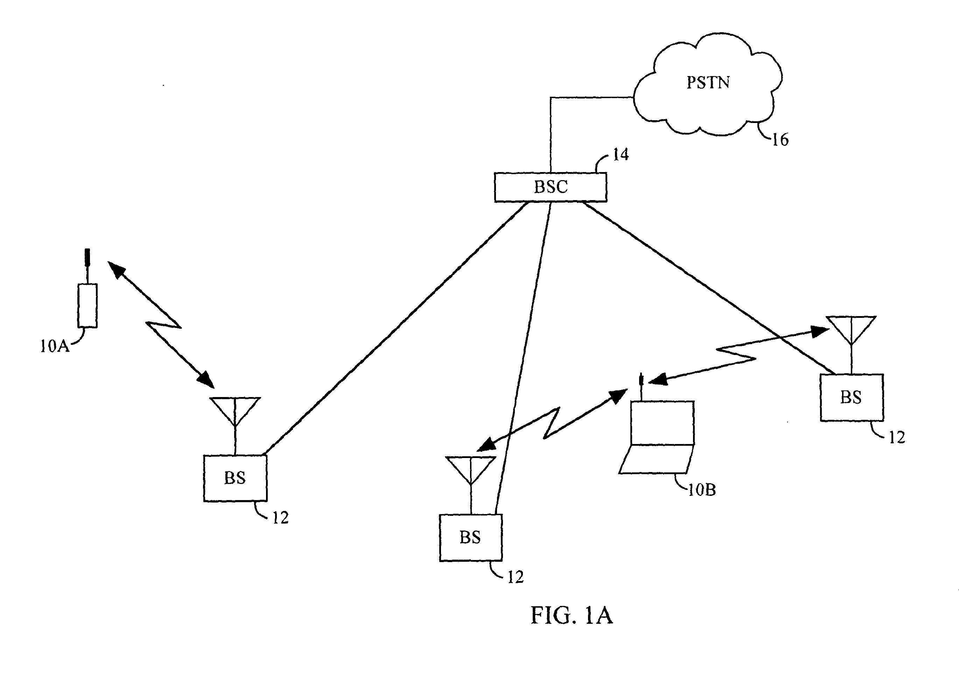

**Fig. 1A** is a highly simplified diagram of a cellular telephone system configured in accordance with one embodiment of the invention. To conduct telephone calls or other communications, subscriber units **10** interface with base stations **12** via RF signals. Base stations **12** interface with the public switch telephone network via base station controller (BSC) **14.**

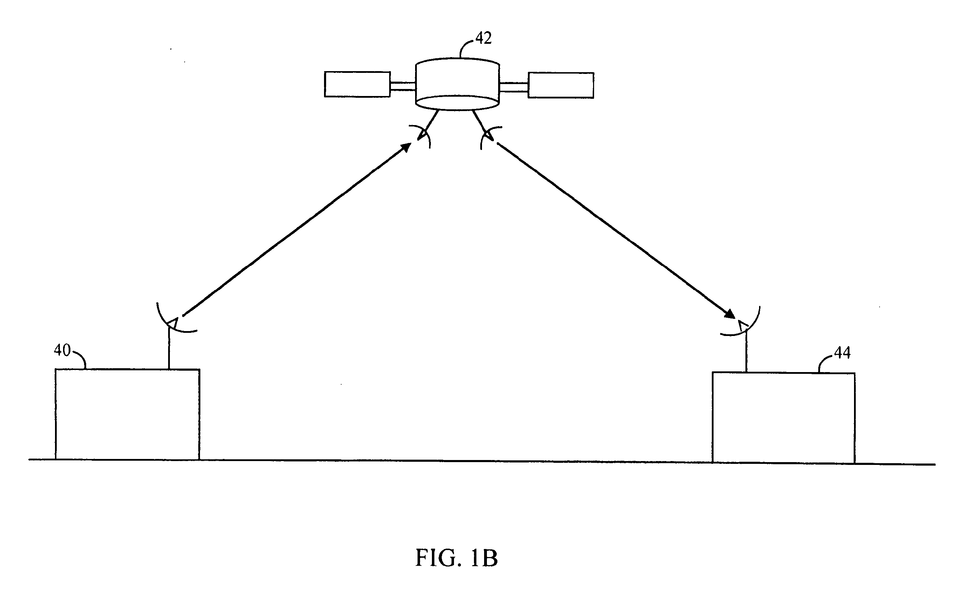

**Fig. 1B** is a highly simplified diagram of a satellite communications system configured in accordance with another embodiment of the invention. Uplink station **40** transmits RF signals containing information such as video programming to satellite **42.** Satellite **42** relays the RF signals back to earth where receiver **44** converts the receive RF signals into digital data.

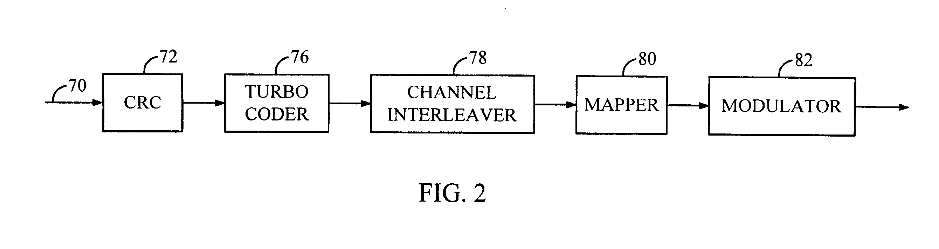

**Fig. 2** is a block diagram of an exemplary transmit system configured in accordance with the use of one embodiment present invention. The transmit system can be used within a subscriber unit **10,** a base stations **12,** or uplink station **40,** as well as any other system that generates digital signals for transmission. The transmit processing shown represent just one possible embodiment of the invention, as numerous other transmit processing schemes may incorporate and benefit from the use of various embodiments of the invention.

Data **70** is supplied to CRC generator **72** which generates CRC checksum data for a given each predetermined amount of data received. The resulting data blocks are supplied to turbo coder **76** which generates code symbols that are supplied to channel interleaver **78.** The code symbols typically include a retransmission of the original data (the systematic symbol), and one or more parity symbols.

The number of parity symbols transmitted for each systematic symbol depends on the coding rate. For a coding rate of _ one parity symbol is transmitted for every systematic symbol, for a total of two symbols generated for each data bit (including CRC) received. For a rate 1/3 turbo coder, two parity symbols are generated for each systemic symbol, for a total of three symbols generated for each data bit received.

The code symbols from the turbo coder **76** are supplied to channel interleaver **78.** Channel interleaver **78** performs interleaving on blocks the symbols as they are received, outputing interleaved symbols that are received by mapper **80.** Typically, channel interleaver **78** performs block or bit-reversal interleaving, virtually all other types of interleavers many be used as the channel interleaver.

Mapper **80** takes the interleaved code symbols and generates symbol words of certain bit width based on a predetermined mapping scheme. The symbol words are then applied to modulator **82** which generates a modulated wave form based on the symbol word received. Typical modulation techniques include QPSK, 8-PSK, and 16 QAM, although various other modulation schemes may be utilized. The modulated waveform is then upconverted for transmission at an RF frequency.

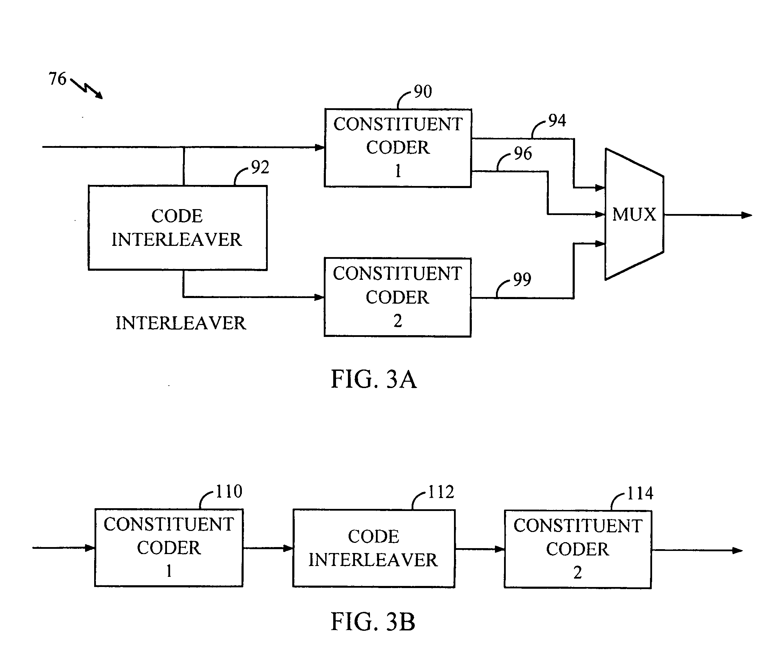

**Fig. 3A** is a block diagram of a turbo coder configured in accordance with a first embodiment of the invention. In this first embodiment of the invention, the turbo coder is configured as a parallel concatenated turbo coder. Within the version of the turbo coder **76,** constituent coder **90** and code interleaver **92** receive the data from CRC generator **72,** which as described above output the input data and CRC checksum bits. Constituent coder **90** also generates tail bits to provide a known state at the end of each frame.

As is well known, code interleaver **92** should be a highly randomized interleaver for the best performance. An interleaver that provides excellent performance with minimal complexity as a code interleaver is described in copending U.S. Patent Application Serial No. 09/158,459 filed September 22, 1998 entitled "Coding System Having State Machine Based Interleaver", and co-pending Continuation-In-Part Application Serial No. 09/172, 069, filed October 13, 1998 entitled "Coding System Having State Machine Based Interleaver", and U.S. Patent Application Serial No. 09/ 09/205511 filed December 4, 1998 entitled "Turbo Code Interleaver Using Linear Cogruential Sequence", all assigned to the assignee of the present application. Constituent coder **90** outputs systematic symbols **94** (typically a copy of the original input bits) and parity symbols **96.** Constituent coder **98** receives the interleaved output of code interleaver **92** and outputs additional parity symbols **99.** Constituent coder **90** may also adds tail bits to provide a known state at the end of each frame.

The outputs of constituents coder **90** and constituent coder **98** are muxed into the output data stream for a total coding rate R of 1/3. Additional constituent codes and code interleaver pairs may be added to reduce the coding rate for increased forward error correction. Alternatively, some of the parity.symbols **96** and **99** may be punctured (not transmitted) to increase the coding rate. For example, the coding rate could be increased to _ by puncturing every other parity symbol **96** and **99,** or not transmitting parity symbol **96** at all.

Constituent coders **90** and **98** may be various types of coders including block coders or convolutional coders. As convolutional coders, constituent coders **90** and **98** typically have a small constraint length such as 4 (four) to reduce complexity, and are recursive systematic convolutional (RSC) encoders. The lower constraint length reduces the complexity of the corresponding decoder at the receive system.

Typically, the two coders output one systematic symbol and one parity symbol for each bit received for a constituent coding rate R = _ . The total coding rate for the turbo coder of **Fig. 3A** is R = 1/3, however, because the systematic bit from constituent coder **98** is not used. As noted above, additional interleaver and coder pairs may also be added in parallel to reduce the coding rate, and therefore provide -higher error correction, or puncturing can be performed to increase the coding rate.

**Fig. 3B** depicts turbo coder **76** as a serial concatenated turbo coder in accordance with an alternative embodiment of the invention. Within the turbo coder of **Fig. 3B**, the data from CRC generator **72** is received by constituent coder **110** and the resulting code symbols are applied to code interleaver **112.** The resulting interleaved parity symbols are supplied to constituent coder **114**, which performs additional encoding to generate parity symbols **115.** Typically, constituent coder **110** (the outer coder) may be various types of encoders including block encoders or convolutional encoders, but constituent coder **114** (the inner coder) is preferably a recursive coder and is typically a recursive systematic encoder.

As recursive systematic convolutional (RSC) encoders, constituent coders **110** and **114** generate symbols at a coding rate R < 1. That is, for a given number of input bits N, M output symbols are generated where M > N. The total coding rate for the serial concatenated turbo coder of **Fig. 3B** is the coding rate of constituent coder **110** multiplied by the coding rate of constituent coder **114.** Additional interleaver and coder pairs may also be added in series to reduce the coding rate and therefore provide additional error protection.

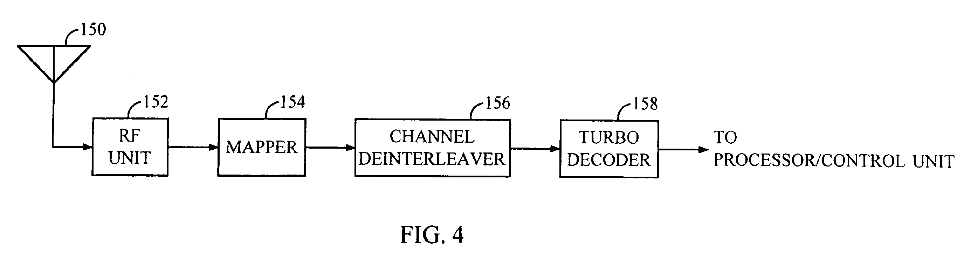

**Fig. 4** is a block diagram of a receive system configured in accordance with one embodiment of the invention. Antenna **150** provides the received RF signals to RF unit **152**. RF unit performs downconvertion, filtering, and digitization of the RF signals. Mapper **140** receives the digitized data and provides soft decision data to channel deinterleaver **156.** Turbo decoder **158** decodes the soft decision data from channel deinterleaver **156** and supplies the resulting hard decision data to the processor or control unit at the receive system, which can check the accuracy of the data using the CRC checksum data.

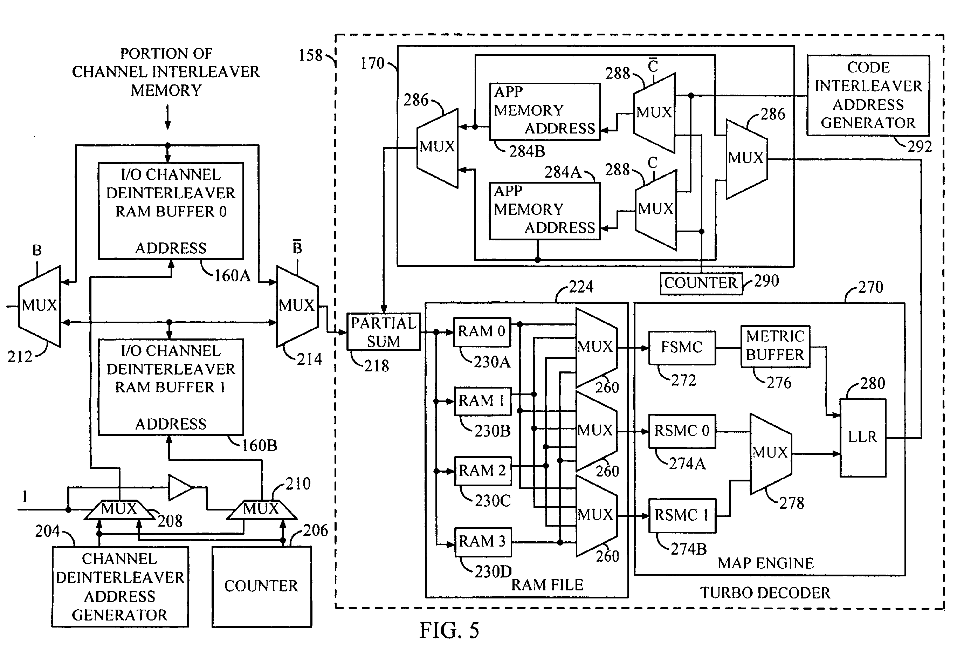

**Fig. 5** is a block diagram of turbo decoder **158** and a portion of the channel deinterleaver when configured in accordance with one embodiment of the invention. As shown, the turbo decoder **158** is configured for decoding the data from the turbo coder shown in **Fig 3A****.**

In the described embodiment, two banks of channel interleaver memory are provided-channel deinterleaver RAMs **160a** and **160b**-with each bank capable of storing one channel interleaver block. The address input of the two channel interleaver memory banks are controlled by channel address generator **204** and counter **206,** which are applied to the address inputs via multiplexers **208** and **210.** Multiplexers **208** and **210** are controlled by signal I and !I (the logical inverse of I), and therefore when one channel deinterleaver RAM is controller by channel deinterleaver address generator **204** the other is controlled by counter **206.** In general, any control functionality may be provided by a microprocessor running software stored in memory, and by discrete logic circuits, although the use of various other types of control systems are consistent with the use of the invention.

The I/0 ports of channel interleaver memory banks are coupled to multiplexers **212** and **214.** Multiplexer **212** receives the soft decision data from mapper **140** to one of the two channel deinterleaver memory banks. Multiplexer **214** outputs the soft decision data stored in one of the two channel deinterleaver memory banks to partial sum **218.** Multiplexors **212** and **214** are controlled by signal B and !B respectively, and therefore when one channel deinterleaver RAM is receiving samples from mapper **140,** the other is outputting samples to partial sum **218.**

During operation, channel deinterleaver address generator **204** is applied to the channel deinterleaver memory bank receiving sample from mapper **140.** Channel deinterleaver address generator generates addresses in inverse order with respect to the interleaving performed by channel interleaver **78** of **Fig. 3****.** Thus, the samples are read into the channel deinterleaver memory bank 160 in non interleaved order (non interleaved with respect to the channel interleaver).

Counter **206** is applied to the channel deinterleaver memory bank reading out the soft decision to partial sum **218.** Since the soft decision data was read in inverse order, the soft decision data may be read out in deinterleaved order simply using counter **206.** Various other methods of buffering the soft decision data may also be used, including the use of dual-port memory. Also, other method of generating the deinterleaver addresses may be used, including switching counter **206** and channel deinterleaver address generator **204.**

Within turbo coder **158,** partial sum **218** receives the receive estimates (soft decision data) from the channel deinterleaver as well as *a priori* probability (APP) data from APP memory **170.** As is well known, the APP values are the estimates of the data transmitted based on the previous decoding iteration. During the first iteration, the APP values are set to an equal probability state.

The estimates from the channel deinterleaver memory include estimates of the systematic symbol as well as estimates of two parity symbols for each data bit associated with the channel interleaver block. Partial sum **218** adds the APP value to the systematic symbol, to create a "refined systematic estimate." The refined systematic estimate, along with the two party symbol estimates, are read into RAM file **224**.

Within RAM file **224,** the estimation values are written into window RAMs **230a** - **d** (labeled RAM 0 - RAM 3). In one embodiment of the invention, the estimates are written in sequential order into the address space of RAMs 0 - 3. This process starts with RAM 0, and proceeds through RAM 3. At any given time, only one window RAM is written to. The three remaining window RAMs (those not being written to) are applied to (read by) MAP engine **270** via multiplexers **260** as described in greater detail below.

In one embodiment of the invention, a sliding window architecture is employed for performing the map decoding. A system and method for performing this sliding window decoding is described in copending US patent application serial no 08/743,688 entitled "Soft Decision Output Decoder for Decoding Convolutionally Encoded Codewords" assigned to the assignee of the present invention.

In that application, the MAP decoding is performed on "windows" of data. In the described embodiment of the invention, RAM window banks **230** are Lxq in size, where L is the number of transmitted data bits in the window and q is the number of memory bits necessary to store the estimates of the refined systematic symbol and the two parity symbols generated for each data bit. In one embodiment of the invention, six (6) bits are used for the two parity symbol estimates and seven (7) bits are used for the refined systematic symbol estimates (which as described above is the summation of the receive systematic symbol estimate and the APP value), for a q of eighteen (18) bits.

As noted above, the estimates, including the refined systematic symbol estimate and the parity symbol estimates, are written into window RAMs **230a - d** in sequential order. Typically, only one window RAM **230** is being written to, and the remaining three window RAMs **230** are read by MAP engine **270.**

In an exemplary processing, data from a new channel block is first written into window RAM **230a** and then window RAM **230b.** Thus, window RAM **230a** contains the first L (1L) set of estimates (where a set comprises the refined systematic estimate and the two parity estimates) and window RAM **230b** contains the second L (2L) set of estimates. Upon storing the first two sets of L estimates within window RAMs **230,** multiplexers **260** begin to apply the data stored in window RAMs **230** into the state metric calculators (SMC) within maximum a prior (MAP) decoder **270.** In one embodiment of the invention, the three SMCs are comprised of a forward SMC (FSMC) **272** and two reverse SMCs (RSMC) **274a** and **274b.**

As data continues to be written into RAM file **224,** multiplexers **260** apply the estimates stored in the three of the four window RAMs to the three state metric calculators within MAP decoder **270** in accordance with Table I.

**Table I.**

| Time | 1L | 2L | 3L | 4L | 5L | 6L | 7L | 8L |
|---|---|---|---|---|---|---|---|---|
| SMC | | | | | | | | |
| FSMC | | RAM 0 | RAM 1 | RAM 2 | RAM 3 | RAM 0 | RAM 1 | |
| | | 0->L-1 | L->2L-1 | 2L->3L-1 | 3L->4L-1 | 4L->5L-1 | 5L->6L-1 | |
| RSMC 0 | | *RAM 1* | RAM 0 | *RAM 3* | RAM 2 | *RAM 1* | RAM 0 | |
| | | *2L-1->L* | L-1->0 | *4L-1->3L* | 3L-1->2L | *6L-1->5L* | 5L-1->4L | |
| RSMC 1 | | | *RAM 2* | RAM 1 | *RAM 0* | RAM 3 | | RAM 1 |
| | | | *3L-1->2L* | 2L-1->L | *5L-1->4L* | 4L-1->3L | | 6L-1->5L |
| LLR | | | | | | | | |

Along with the particular window RAM applied to the particular state metric, Table I also lists the set of estimates contained in that window RAM at the time, and therefore the estimates processed by the corresponding SMC.

A window is processed once in the forward direction and once in the reverse direction in accordance with MAP processing. Additionally, most windows are processed an additional time in the reverse direction to generate an initialization state for the other reverse state metric processing. In Table 1., the initialization passes are denoted by the italicized text. In the described embodiment, each set of estimates is processed three times, and therefore the window RAM in which the estimates are stored is accessed three times as well. Using 3 window RAMs prevents RAM contention.

As also shown by Table I, at any particular time at least one window RAM is not coupled to any SMC, and therefore is available to have new data written in. By having more that three windows of RAM within RAM file **224,** data can be continuously and repeatedly feed to MAP engine in the correct sequence, and to the correct one of the three SMCs, while simultaneously received from channel interleaver memory **160** via partial sum **218.**

It should also be noted that Table I illustrates the coupling performed for six (6) windows of data. Thus, the exemplary channel interleaver block size is 6L, and the channel deinterleaver memory is 6Lxq. The channel block size of 6L is for example only, and the typical channel block size will be larger than 6L.

Still referring to **Fig. 5****,** within MAP decoder **270,** FSMC **272** receives the estimates from RAM file **224** as described above and calculates forward state metric values over a window L. The forward state metric values are stored in metric buffer **276.** Additionally, according to Table I, one RSMC **274** calculates reverse state metric values over a another window L. In one embodiment of the invention, each state metric calculator contains its own branch metric calculator. In other embodiments of the invention a single time shared branch metric calculator may be used on the set of state metrics, preferably in combination with a branch metric buffer.

In one embodiment of the invention, the MAP decoder used is a log-MAP decoder, which operates on the logarithm of the estimates to reduce the hardware complexity. One implementation of a log-MAP decoder including state metric and branch metric calculators is described in the reference S.S. Pietrobon, "Implementation and Performance of a Turbo/MAP Decoder," submitted to the International Journal of Satellite Communications, February 1997. The log-MAP decoder of Pietrobon does not use the sliding window architecture described in the above referenced "Soft Decision Output Decoder for Decoding Convolutionally Encoded Codewords" patent application.

The last value calculated by the first RSMC **274** is used to initialize the other RSMC **274,** which performs a reverse state metric calculation on the window L for which forward state metrics have already been calculated and stored in metric buffer **276.** As the reverse state metrics are calculated, they are forwarded, via multiplexer **278,** to the log likelihood ratio (LLR) calculator **280.** LLR calculator **280** performs a log likelihood calculation of the reverse state metrics received from mux **278** and the forward state metrics stored in metric buffer **276.** The resulting data estimates from LLR **280** are forwarded to APP memory **170.**

By using a sliding metric calculation process, the amount of memory used to perform the necessary processing is reduced. For example, the set of window RAMs **230** need only be as large as the window L, rather than the size of the entire interleaver block. Similarly, only one window L of forward state metrics need to be stored within metric buffer **276** at any given time. This reduces circuit size significantly.

Additionally, the use of three metric calculators significantly increases the rate at which decoding can be performed. The rate is increased, because the initialization and decoding functions can be performed in parallel. Initialization increases the accuracy of the decoder.

In alternative embodiments of the invention, two forward state metric calculators may be used in conjunction with one reverse state metric calculator. Also, fewer state metric calculators may be used if clocked at a sufficiently high rate to perform twice as many operations. However, increasing the clock rate increases power consumption which is undesirable in many instances including in mobile or battery powered communication systems.

Additionally, while the use of RAM file **224** reduces circuit area and RAM contention within the decoder, other embodiments of the invention may select alternative memory architectures.

As described above with reference to the exemplary embodiment, the decoding is done by performing a first decoding a first window in first direction and simultaneously performing a second decoding on a second window in second direction. The second direction is preferably the opposite of the first direction.

The results of the first decoding are stored. The results of the second decoding are used to initialize a third decoding performed on the first window in the second direction. During the third decoding, the LLR values are calculated using the values calculated during the third decoding and the stored values.

Simultaneous with the third decoding, a forth decoding of another window is performed in the first direction, as well as a fifth decoding in the second direction on still another window. The results of the forth decoding are stored, and the fifth decoding is used to generate an initialization value. These steps are repeated until the entire channel interleaver block is decoded.

Various alternative embodiments of the invention may omit some of the steps used in the described embodiment. However, the use of the set of steps described provides rapid and accurate decoding with a minimum of memory and additional circuitry, and therefore provides significant performance benefits.

In one embodiment of the invention, APP memory **170** is comprised of two APP memory banks **284.** Multiplexers **286** switch each memory bank **284** between being read by partial sum **218,** and being written to by LLR **280** to provide double buffered operation. Multiplexers 288 apply either a counter **290** or the code interleaver address generator **292** so as to perform turbo code interleaving and inverse interleaving for each iteration of decoding.

Also, APP memory banks **284** may be large enough to hold all the data estimates for one channel interleaver block, where the estimates are of the data transmitted and not the parity symbols. Estimates of six bits resolution may be used.

The entire decoding process proceeds by repeatedly reading out the receive estimates from a channel deinterleaver buffer **160** and processing with the APP values from APP memory bank **170.** After a series of iterations, the estimates should converge on a set of values that are then used for generating hard decisions. The results of the decoding are then checked using the CRC values. Simultaneous with the decoding, the other channel deinterleaver buffer receives the next block of receive estimates.

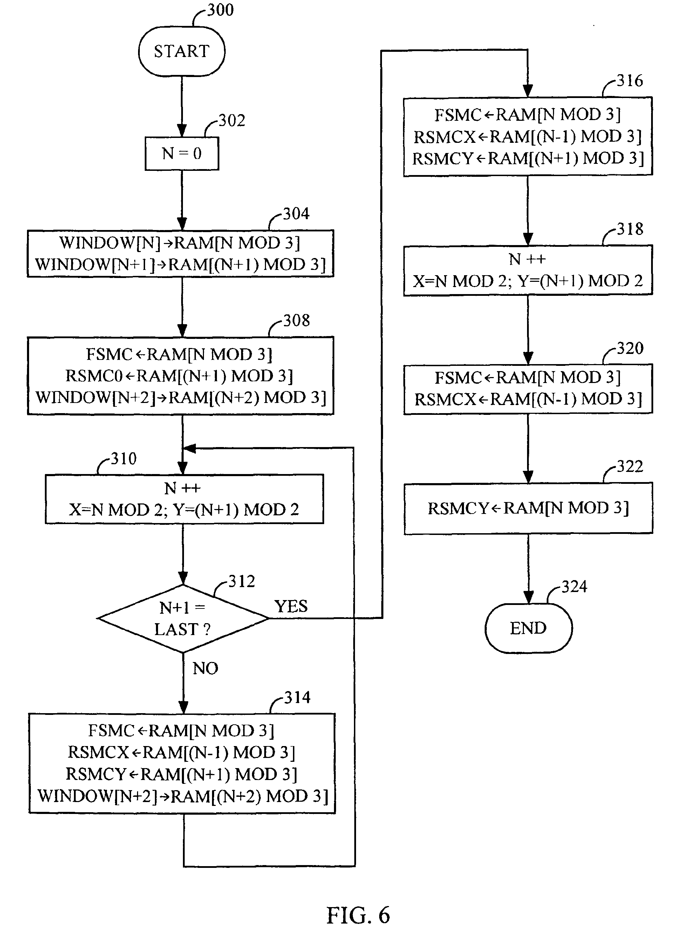

**Fig. 6** is a flow chart illustrating the steps performed during log-MAP decoding of a channel interleaver block in accordance with one embodiment of the invention. The steps are discussed with reference to the elements shown in Fig. 5.

The decoding begins at step **300** and at step **302** window index N is set to 0. At step **304** window[N] and window[N+1} of the estimates stored in channel deinterleaver RAM are written into window RAM[N mod 3] and window RAM[(N+1) mod 3] respectively. As noted above, a window of estimates corresponds to the symbols generated with respect to a window L of data bits being transmitted.

At step **308,** FSMC processes the estimates in RAM[N mod 3] (which in this case is RAM 0) and RSMC 0 processes the estimates in RAM[(N+1) mod 3] (which is RAM 1). Additionally, window[N+2] of estimates from the channel deinterleaver RAM is written into window RAM[(N+2) mod 3] (which is RAM 2).

At step **310,** window index N is incremented and X is set to N mod 2 and Y is set to (N+1) mod 2. At step **312** it is determined whether N+1 corresponds to the last window of estimates to be processed. If not,, step **314** is performed.

At step **314,** FSMC processes the estimates stored in window RAM[N mod 3], RSMC X (X=0 in the first pass) processes the estimates stored in window RAM[(N+1) mod 3], and RSMC Y (Y = 1 in the first pass) processes the estimates stored in window RAM[(N-1) mod 3]. Additionally, window[N+2] of estimates from channel deinterleaver RAM are written to window RAM[(N+2) mod 3].

Not shown, is that a set of APP values corresponding to window[N-1] of data are generated at step **314** during the processing performed by RSMC 1. By performing the decoding over windows, the size of the metric buffer is kept to length L times the number of metrics generated for each decoding step. Since numerous metrics are stored for each decoding step, the reduction in metric memory is significant as compared to storing the state metrics for the entire channel deinterleaver block.

Additionally, the use of the second reverse state metric calculator increases speed and accuracy. For example, the second RSMC can calculate a new initial value for the next decoding window while the previous decoding window is being processed. Calculating this new initial value eliminates the need to perform new RSMC calculations for each decoding step, as the new value can be used for decoding all of the previous window.

Step **314** provides an excellent illustration of the efficiencies gained by processing the estimates as exemplified by RAM file **224.** In particular, step **314** illustrates the ability to perform four steps in the decoding processing simultaneously. This increases the rate at which coding can be performed for a given clock rate. In the described embodiment, the steps include the state metric calculation processing and the writing of additional samples to RAM file **224.** Also, the APP values are calculated during step **314.**

Once step **314** is completed, the window index N is incremented at step **310.** If the value N+1 is equal to the last window, then the pipeline processing is discontinued, and the remaining estimates within RAM file **224** are processed at steps **316** through **322.**

In particular, at step **316** the FSMC processes window RAM[N mod 3], RSMC X processes window RAM[(N+1) mod 3] and RSMC Y processes window RAM[(N±1) mod3]. At step **318** window index N is incremented, X is set to N mod 2 and Y is set to (N+1) mod 2. At step **320** FSMC processes RAM[N mod 3] and RSMC Y processes RAM[(N-1) mod 3]. At step **322** RSMC 1 processes RAM[N mod 3]. At step **324** the channel deinterleaver block has been completed at the processing terminates.

Thus, a novel and improved technique for performing turbo coding has been described.

## Claims

1. A system for performing sliding window maximum a posteriori probability, in the following referred to as MAP, decoding comprising:
a) channel deinterleaver RAM (160) for storing a block of symbol estimates;
b) a total of S state metric calculators (272, 274), each state metric calculator for generating a set of state metric calculations, wherein said state metric calculators (272, 274) process data over windows equal to or less than the size of a window RAM;
c) set of S+1 window RAMs (230A-D), wherein, S of said S+1 window RAMs provide symbol estimates to said S state metric calculators, and a remaining window RAM receives symbol estimates from said channel deinterleaver RAM (160).

2. The system as set forth in claim 1 wherein S is equal to 3.

3. The system as set forth in claim 1 wherein said window RAMs (230A-D), are smaller than said channel deinterleaver RAM (160).

4. The system as set forth in claim 1 comprising a decoder, said decoder comprising:
channel interleaver memory for storing a channel interleaver block of receive estimates, said memory comprising said channel deinterleaver RAM (160);
decoder engine (270) for decoding receive estimates, said decoder engine (270) comprising the S state metric calculators (272, 274) ;
decoder buffer comprising said set of S+1 window RAMs (230A-D), said decoder buffer for simultaneously reading out a first set of receive estimates and a second set of receive estimates to said decoder engine (270) and writing in a third set of receive estimates from said channel interleaver memory.

5. The system as set forth in claim 4, wherein said decoder buffer is further for simultaneously reading out a fourth set of receive estimates.

6. The system as set forth in claim 4, wherein said decoder engine (270) is a MAP decoder engine.

7. The system as set forth in claim 4, wherein said decoder engine (270) is comprised of:
forward state metric calculator for generating forward state metrics in response to said first set of receive estimates;
reverse state metric calculator for generating reverse state metrics in response to said second set of receive estimates.

8. The system as set forth in claim 5, wherein said decoder engine (270) is comprised of:
forward state metric calculator for generating forward state metrics in response to said first set of receive estimates;
first reverse state metric calculator for generating reverse state metrics in response to said second set of receive estimates;
and second reverse state metric calculator for generating reverse state metrics in response to said fourth set of receive estimates.

9. A method for performing sliding window maximum a posteriori probability decoding, the method comprising:
a) storing a block of symbol estimates in a channel deinterleaver RAM (160);
b) generating a set of state metric calculations in a total of S state metric calculators (272, 274), wherein said state metric calculators (272, 274) process data over windows equal to or less than the size of a window RAM,
c) providing symbol estimates to said S state metric calculators from S of a set of S+1 window RAMs (230A-D), and receiving symbol estimates at a remaining window RAM from said channel deinterleaver RAM (160).

## Patentansprüche

1. Ein System zum Durchführen einer Decodierung mit maximaler A-Posteriori-Wahrscheinlichkeit, was im Folgenden als MAP bezeichnet wird, bei einem gleitenden Fenster bzw. einer Gleitfenster-MAP-Decodierung, wobei das System Folgendes aufweist:
a) einen Kanal-Deinterleaver-RAM (160) zum Speichern eines Blocks von Symbolschätzungen;
b) eine Gesamtanzahl von S Zustandsmetrikberechnungselementen (272, 274), wobei jedes Zustandsmetrikberechnungselement vorgesehen ist, um einen Satz von Zustandsmetrikberechnungen zu generieren, wobei die Zustandsmetrikberechnungselemente (272, 274) Daten über Fenster verarbeiten, die gleich oder kleiner sind als die Größe eines Fenster-RAM;
c) einen Satz von S+1 Fenster-RAMs (230A-D), wobei S der S+1 Fenster-RAMs Symbolschätzungen an die S Zustandsmetrikberechnungselemente liefern, und ein verbleibender Fenster-RAM Symbolschätzungen von dem Kanal-Deinterleaver-RAM (160) empfängt.

2. System nach Anspruch 1, wobei S gleich 3 ist.

3. System nach Anspruch 1, wobei die Fenster-RAMs (230A-D) kleiner sind als der Kanal-Deinterleaver-RAM (160).

4. System nach Anspruch 1, das einen Decodierer aufweist, wobei der Decodierer Folgendes aufweist:
einen Kanal-Interleaver-Speicher zum Speichern eines Kanal-Interleaver-Blocks von Empfangsschätzungen; wobei der Speicher den Kanal-Deinterleaver-RAM (160) aufweist;
eine Decodierer-Engine (270) zum Decodieren von Empfangsschätzungen,
wobei die Decodierer-Engine (270) die S Zustandsmetrikberechnungselemente (272, 274) aufweist:
einen Decodiererpuffer, der den Satz von S+1 Fenster-RAMs (230A-D) aufweist, wobei der Decodiererpuffer vorgesehen ist, um gleichzeitig einen ersten Satz von Empfangsschätzungen und einen zweiten Satz von Empfangsschätzungen für die Decodierer-Engine (270) auszulesen und in einen dritten Satz von Empfangsschätzungen vom Kanal-Interleaver-Speicher zu schreiben.

5. System nach Anspruch 4, wobei der Decodiererpuffer weiter gleichzeitig einen vierten Satz von Empfangsschätzungen ausliest.

6. System nach Anspruch 4, wobei die Decodierer-Engine (270) eine MAP-Decodierer-Engine ist.

7. System nach Anspruch 4, wobei die Decodierer-Engine (270) Folgendes aufweist:
ein Vorwärts-Zustandsmetrikberechnungselement zum Generieren von Vorwärtszustandmetriken ansprechend auf den ersten Satz von Empfangsschätzungen;
ein Rückwärts-Zustandsmetrikberechnungselement zum Generieren von Rückwärtszustandsmetriken ansprechend auf einen zweiten Satz von Empfangsschätzungen.

8. System nach Anspruch 5, wobei die Decodierer-Engine (270) Folgendes aufweist:
ein Vorwärts-Zustandsberechnungselement zum Generieren von Vorwärtszustandsmetriken ansprechend auf den ersten Satz von Empfangsschätzungen;
ein erstes Rückwärts-Zustandsmetrikberechnungselement zum Generieren von Rückwärts-Zustandsmetriken ansprechend auf den zweiten Satz von Empfangsschätzungen;
und ein zweites Rückwärts-Zustandsmetrikberechnungselement zum Generieren von Rückwärtszustandsmetriken ansprechend auf den vierten Satz von Empfangsschätzungen.

9. Ein Verfahren zum Durchführen einer Decodierung mit maximaler A-Posteriori-Wahrscheinlichkeit bei einem gleitenden Fenster bzw. einer Gleitfenster-MAP-Decodierung, wobei das Verfahren Folgendes aufweist:
a) Speichern eines Blocks von Symbolschätzungen in einem Kanal-Deinterleaver-RAM (160);
b) Generieren eines Satzes von Zustandsmetrikberechnungen in einer Gesamtanzahl von S Zustandsmetrikberechnungselementen (272, 274), wobei die Zustandsmetrikberechnungselemente (272, 274) Daten über Fenster verarbeiten, die gleich oder kleiner sind als die Größe eines Fenster-RAM,
c) Liefern von Symbolschätzungen an die S Zustandsmetrikberechnungselemente von S eines Satzes von S+1 Fenster-RAMs (230A-D), und Empfangen von Symbolschätzungen bei einem verbleibenden Fenster-RAM von dem Kanal-Deinterleaver-RAM (160).

## Revendications

1. Système pour réaliser un décodage à probabilité maximale à postériori en fenêtre glissante, appelé dans la suite MAP, comprenant :
a) une RAM de désentrelaceur de canal (160) pour mémoriser un bloc d'estimations de symboles ;
b) un total de S calculateurs de métriques d'état (272, 274), chaque calculateur de métriques d'état étant destiné à générer un ensemble de calculs de métriques d'état, lesdits calculateurs de métriques d'état (272, 274) traitant des données sur des fenêtres égales ou inférieures à la taille d'une RAM de fenêtre ;
c) un ensemble de S+1 RAM de fenêtre (230A-D), dans lequel S desdites S+1 RAM de fenêtre fournissent des estimations de symboles aux S calculateurs de métriques d'état, et une RAM de fenêtre restante reçoit des estimations de symboles à partir de la RAM de désentrelaceur de canal (160).

2. Système selon la revendication 1, dans lequel S est égal à 3.

3. Système selon la revendication 1, dans lequel les RAM de fenêtre (230A-D) sont plus petites que la RAM de désentrelaceur de canal (160).

4. Système selon la revendication 1, comprenant un décodeur, le décodeur comprenant :
une mémoire d'entrelaceur de canal pour mémoriser un bloc d'entrelaceur de canal d'estimations de réception, ladite mémoire comprenant la RAM de désentrelaceur de canal (160) ;
un moteur de décodeur (270) pour décoder des estimations de réception, ledit moteur de décodeur (270) comprenant les S calculateurs de métriques d'état (272, 274) ;
un tampon de décodeur comprenant ledit ensemble de S+1 RAM de fenêtre (230A-D), le tampon de décodeur étant destiné à lire simultanément un premier ensemble d'estimations de réception et un deuxième ensemble d'estimations de réception vers le moteur de décodeur (270) et à écrire dans un troisième ensemble d'estimations de réception à partir de la mémoire d'entrelaceur de canal.

5. Système selon la revendication 4, dans lequel le tampon de décodeur est en outre destiné à lire simultanément un quatrième ensemble d'estimations de réception.

6. Système selon la revendication 4, dans lequel le moteur de décodeur (270) est un moteur de décodeur MAP.

7. Système selon la revendication 4, dans lequel le moteur de décodeur (270) comprend :
un calculateur de métriques d'état directes pour générer des métriques d'état directes en réponse au premier ensemble d'estimations de réception ;
un calculateur de métriques d'état inverses pour générer des métriques d'état inverses en réponse au deuxième ensemble d'estimations de réception.

8. Système selon la revendication 5, dans lequel le moteur de décodeur (270) comprend :
un calculateur de métriques d'état directes pour générer des métriques d'état directes en réponse au premier ensemble d'estimations de réception ;
un premier calculateur de métriques d'état inverses pour générer des métriques d'état inverses en réponse au deuxième ensemble d'estimations de réception ;
et un second calculateur de métriques d'état inverses pour générer des métriques d'état inverses en réponse au quatrième ensemble d'estimations de réception.

9. Procédé de réalisation d'un décodage à probabilité maximale à postériori en fenêtre glissante, le procédé comprenant les étapes suivantes :
a) mémoriser un bloc d'estimations de symboles dans une RAM de désentrelaceur de canal (160) ;
b) générer un ensemble de calculs de métriques d'état dans un total de S calculateurs de métriques d'état (272, 274), les calculateurs de métriques d'état (272, 274) traitant des données sur des fenêtres égales ou inférieures à la taille d'une RAM de fenêtre,
c) fournir des estimations de symboles aux S calculateurs de métriques d'état à partir de S d'un ensemble de S+1 RAM de fenêtre (230A-D), et recevoir des estimations de symboles au niveau d'une RAM de fenêtre restante à partir de la RAM de désentrelaceur de canal (160).
